# EUROPEAN PATENT SPECIFICATION

(11) **EP 3 939 398 B1**
(45) Date of publication and mention of the grant of the patent: **06.08.2025**
(21) Application number: 20711547.8
(22) Date of filing: 10.03.2020
(51) Int. Cl.: F28D 15/02, H01L 23/473, H05K 7/20, H01L 23/46, F28F 13/16

(54) **ARRANGEMENT FOR COOLING OF ELECTRONIC COMPONENTS BY USING AN ELECTROHDRODYNAMIC FLOW UNIT**
ANORDNUNG ZUR KÜHLUNG VON ELEKTRONISCHEN BAUTEILEN UNTER VERWENDUNG EINER ELEKTROHYDRODYNAMISCHEN STRÖMUNGSEINHEIT
AGENCEMENT POUR LE REFROIDISSEMENT DE COMPOSANTS ÉLECTRONIQUES À L'AIDE D'UNE UNITÉ D'ÉCOULEMENT ÉLECTRODYNAMIQUE

(30) Priority: 11.03.2019 SE 1950305
(43) Date of publication of application: 19.01.2022
(73) Proprietor: APR Technologies AB, 745 39 Enköping (SE)
(72) Inventor: BJÖRNEKLETT, Are, 723 55 Västerås (SE); NILSSON, Peter, 174 46 Sundbyberg (SE); THORSLUND, Robert, 193 91 Sigtuna (SE)
(74) Representative: AWA Sweden AB
(86) International application number: PCT/EP2020/056371
(87) International publication number: WO 2020/182821

(56) References cited:
- WO-A1-2017/127017
- FR-A1- 3 063 806
- JP-A- 2010 147 286
- JP-A- 2014 212 625
- US-A1- 2004 190 254

## Description

### TECHNICAL FIELD

The invention disclosed herein relates to the field of thermal management, and more specifically thermal management of heat generating electrical components.

### BACKGROUND

The performance of electronic systems is often limited by the thermal management techniques available. Smaller components with higher power dissipation means greater heat generation in smaller areas. As a result, more efficient thermal management is required for keeping the components within an appropriate temperature range. In other words, there is a growing need for increased efficiency, both in terms of volume requirements and energy.

One attempt to address these issues is the use of immersion cooling, in which a dielectric fluid, which is in direct contact with the electronic device to be cooled, is being circulated using a pump unit. The pump unit may be disposed to actively pump the dielectric fluid onto the electronic device.

However, there is still a need for smaller and more efficient technologies for thermal management in connection with heat generating components.

In the prior art, examples may be found of thermal management systems using electrohydrodynamic, EHD, principles for cooling.

WO 2017/127017 shows a fluidic device for circulating fluid in an enclosed passage, wherein said fluidic device uses electrodes to generate a flow.

FR 3063806 shows a heat transfer device using liquid and electrodes to transfer heat.

JP 2014212625 shows an EHD pump employing sharpened electrodes and slits.

JP 2010147286 discloses a heat sink using electrodes and liquid to transfer heat from a heat generating body.

US 2004/190254 shows an electronic package with fluid cooling and a heat spreader.

### SUMMARY

It is an object of at least some of the embodiments of the present invention to provide an arrangement allowing for an improved thermal management. It is a particular object to improve the efficiency of a circulating dielectric fluid in an electrohydrodynamic, EHD, system.

To better address one or more of these concerns, an arrangement having the features defined in the independent claim is provided. Preferable embodiments are defined in the dependent claims.

According to a first aspect, an arrangement for thermal management is provided, comprising an enclosure configured to accommodate a thermal management fluid, such as for example a dielectric liquid, in thermal contact with a wall portion of the enclosure. The arrangement further comprises an electrohydrodynamic, EHD, flow unit arranged within the enclosure, wherein the EHD flow unit comprises a first electrode and a second electrode arranged offset from the first electrode, and wherein the EHD flow unit is configured to control a flow of the dielectric liquid between the first electrode and the second electrode. The wall portion may be configured to be arranged in thermal contact with the heat generating component so as to allow heat to be dissipated from the heat generating component through the dielectric liquid.

The EHD flow unit may be arranged within the enclosure so as to control or at least affect a flow of the thermal management fluid within the enclosure, and, possibly, also a circulation of the fluid between the enclosure and an external heat transferring device such as a heat exchanger. The flow unit may for example be arranged to direct the fluid towards the wall portion facing the heat generating component, and/or away from the component.

The heat generating component may for example comprise a processor, an electronic circuit, or chip, e.g. in the form of a flip chip device, a tape bonded device, a wire bonded device, or otherwise bonded devices, a printed circuit board or a device mounted on such a board. In one example, the heat generating component may be a battery or capacitor. The arrangement according to the present inventive concept may be configured to be attached either onto the heat generating itself, onto a housing or protective package enclosing the component, or onto a heat spreader or heat sink connected to the component. The EHD flow unit may be activated by applying a voltage difference between the first and second electrodes of the flow unit. The electric field generated by the electrodes may bring the fluid to a flow. By deactivating, or turning off the flow unit, the flow unit may further be put in an operational mode wherein the flow through the flow unit may be reduced or eliminated. This effect may be used to further increase the control of the fluid and thus the cooling effect. The flow unit may be deactivated e.g. by reducing or removing the voltage difference between the electrodes, or applying a voltage difference counteracting a flow through the flow unit.

The first electrode may also be referred to as an "emitter" or "emitter electrode", whereas the second electrode may be referred to as "collector" or "collector electrode". During use, the emitter may be adapted to emit electrons into the fluid and/or to negatively charge matter, such as particles or impurities of the fluid, in a close proximity of the emitter.

The present inventive concept is particularly advantageous when used in combination with a dielectric liquid. The use of the EHD flow unit allows for a flow of the liquid to be directed in a specific direction without using for example manifolds and nozzles.

According to some embodiments, the enclosure may be defined as a volume surrounded by an enclosing barrier, such as e.g. an enclosure wall. The enclosure wall may be attached directly to the heat generating component, or indirectly via for example a thermal interface material, TIM.

The thermal management arrangement according to the present inventive concept may be provided as a separate unit that can be fitted with existing products, which may be commercially available off-the-shelf products. By attaching the arrangement according to the inventive concept to such a product, an improved cooling may be achieved. The arrangement may hence be referred to as a "click on" product that can be adapted to satisfy the thermal management needs of the heat generating component. Alternatively, or additionally, the arrangement may be attached by means of e.g. gluing, screwing or riveting.

According to some embodiments, the enclosed volume may form a closed system in which the fluid may circulate to transfer heat from the component to the enclosure wall. According to other embodiments, the enclosure wall may be provided with inlets and outlets for circulation of thermal management fluid to external parts, such as pumps and heat exchangers.

According to some embodiments, the enclosure may be arranged in thermal contact with a heat exchanger, for example, a carbon fibre structure or a heat pipe for transferring heat from the enclosure. The heat exchanger may for example be attached on top of the enclosure for dissipating heat transferred away from the component via the thermal management fluid. In some embodiments, a thermal interface material, such as graphene, may be arranged between the enclosure wall and the heat exchanger and/or the heat generating component so as to improve the heat transfer.

Further, the arrangement may comprise surface enlarging structures for increasing heat transfer efficiency between the enclosure and the thermal management fluid. Examples of such structures may include microchannels, carbon nanotubes, and other structures resulting in an increased surface with which the thermal management fluid can be brought in contact. Alternatively, or additionally the arrangement may comprise surface structures or materials increasing the wettability of the thermal management fluid in order to further increase the heat transfer efficiency.

According to some embodiments, the arrangement may comprise a plurality of EHD flow units, which may be configured in a similar way as the first EHD flow unit mentioned above. Thus, according to an embodiment, the arrangement may comprise a first and a second electrohydrodynamic, EHD, flow unit, arranged within the enclosure, wherein the first flow unit may be configured to direct the flow towards the heat generating component (i.e., towards the wall portion of the enclosure that is arranged in thermal contact with the heat generating component), and the second flow unit may be configured to direct the flow away from said component.

The present aspect is advantageous in that by arranging the EHD flow units within the enclosure such that they are directed towards and away from the wall portion facing the heat generating component, as well as away from it, a more precise control of the flow and hence a more efficient cooling may be achieved.

The number and configuration of the flow units within the enclosure may be determined by the desired flow to be achieved. For example, flow units may be positioned in a grid structure, either in a common plane or in different layers. This allows for improved control of the fluids' flow in the enclosure, and may make it possible to target certain areas of the walls defining the enclosure. This also means that certain areas may be exposed to less flow, should that be required.

This specific targeting is made possible by the relative orientation of the electrodes forming the flow unit. Furthermore, the relative orientation of the emitter and collector electrodes may affect the angle of the flow towards a surface, or, in some examples, the angle of incidence of the flow on the inner surface of the enclosure. The direction of the flow may for example be perpendicular to an inner surface portion of the enclosure, parallel to a surface of the enclosure, or in a specific angle there between. The orientation and configuration of the flow units may be tailored for a specific application, and the arrangement may therefore be adaptable to a number of different components, thermal interface configurations, and thermal management requirements.

As already mentioned, the thermal management arrangement may be configured to operate with thermal management fluids that are capable of being accelerated by means of the EHD effect. Examples of such fluids, i.e. liquids and gases, that can be pumped by means of embodiments of the invention include e.g. dielectrics such as acetone, alcohols, helium, nitrogen, and fluorocarbon-based fluids such as e.g. Fluorinert^{™}, Galden^{™}, Novec^{™} or the more recently developed environmental friendly replacements, e.g., FluoSolv^{™}. More specifically, the thermal management fluid may be a dielectric fluid suitable for immersion cooling technologies.

In some embodiments, at least one of the first and second electrodes of at least one flow unit may be arranged on an inner surface portion of the enclosure. This would mean utilizing a surface of the enclosure as part of a flow unit, either as a first electrode or as a second electrode, allowing at least a portion of the inner surface of the enclosure to be involved as either a collector or emitter electrode. This may provide an increase in the cooling effect, since the electrode arranged on the inner surface may cause the flow to be drawn to, or impinge directly on, the wall portion that is arranged in thermal contact with the heat generating component.

In further embodiments, the electrode may be formed by providing an electrically conductive layer on an inner surface of the enclosure. This electrically conductive layer may advantageously comprise a material that has a relatively good ability of emitting/receiving electrons. Alternatively, or additionally, the electrically conductive layer may be configured to improve the thermal transfer to or from the surface. Further, the material of the layer may be chemically stable, or inert, in relation to the pumped fluid. Examples of layers for improving the emission/absorption of electrons and/or thermal transfer include 2D and 3D films, for example comprising graphite or graphene. The graphene may for example be provided in one or several layers, such as 2D layers, or in a foam. It is appreciated that the arrangement in addition to the above mentioned electrodes further may comprise a layer or a coating provided in order to improve heat transfer to/from the thermal management fluid. Such a layer, or coating, may in some examples comprise graphite or graphene and may be arranged on a surface defining the enclosure.

Using a wall section of the enclosure as an electrode may provide space efficient solution compared to embodiments having separate flow units, i.e., flow units arranged within the enclosure without forming part of the enclosure wall and/or component.

According to one embodiment, a plurality of flow units may share one or more electrodes. For example, one electrode may function as the collector unit for a multitude of electrodes used as emitter units. The opposite formation, utilising one emitter electrode and a plurality of smaller collector electrodes is also possible.

According to another embodiment of the current invention, a plurality of flow units may be positioned so as to include collector electrodes arranged on an inside of the enclosure wall, preferably at opposing sides - the first side facing the heat generating component, the other side facing a heat exchanger. The emitter electrodes may then be placed in between the collectors, on varying distances to the collector electrodes. The distance between an emitter electrode and a collector electrode may determine the direction the flow will take. Hence, the emitter electrodes arranged closer to the wall facing the heat exchanger may cause a flow towards said heat exchanger and thus form a flow unit having its collector electrode positioned on said wall. The emitter electrodes located closer to the wall facing the heat generating component may form a flow unit directed towards said heat generating component, having its collector electrode positioned the wall facing said component. In other words, the distance between the emitter electrode and the collector electrode may define the orientation of the flow unit.

According to some embodiments, the electrode may comprise a variety of surface structures. The surface may for example be shaped as peaks or provided with a high surface roughness so as to increase the surface area. A relatively large contact surface between the electrodes and the passing fluid may facilitate the interaction between the electrode and the fluid. For example, this may facilitate thermal transfer as well as the injection or absorption of ions or electrons.

Further objectives of, features of and advantages with the present invention will be apparent when studying the following detailed disclosure, the drawings and the appended claims. Those skilled in the art realise that different features of the present invention, even if recited in different claims, can be combined in embodiments other than those described in the following.

### BRIEF DESCRIPTION OF DRAWINGS

The above, as well as additional objects, features and advantages of the present invention, will be better understood through the following illustrative and non-limiting detailed description of embodiments of the present invention. Reference will be made to the appended drawings, on which:
figure 1 is a schematic cross sectional view of an arrangement for thermal management of a heat generating component, comprising an enclosure and a plurality of flow units arranged within the enclosure, according to some embodiments of the present invention;
figure 2 is a schematic cross sectional view of an arrangement for thermal management, comprising an enclosure with inlet and outlets, wherein the arrangement is positioned between an external heat exchanger and a heat generating component according to some embodiments of the present invention;
figures 3a and 3b are schematic cross sectional views of different electrode configurations in flow units;
figures 4a and 4b display exemplary configurations of flow units within an enclosure of an arrangement for thermal management;
figure 5 is a schematic view of an arrangement for thermal management, with increased electrode surface according to one embodiment;
figure 6 is a top view of an embodiment in which a heat generating component is provided with electrodes.

All the figures are schematic, generally not to scale, and generally only show parts which are necessary in order to elucidate the invention, whereas other parts may be omitted or merely suggested.

### DETAILED DESCRIPTION

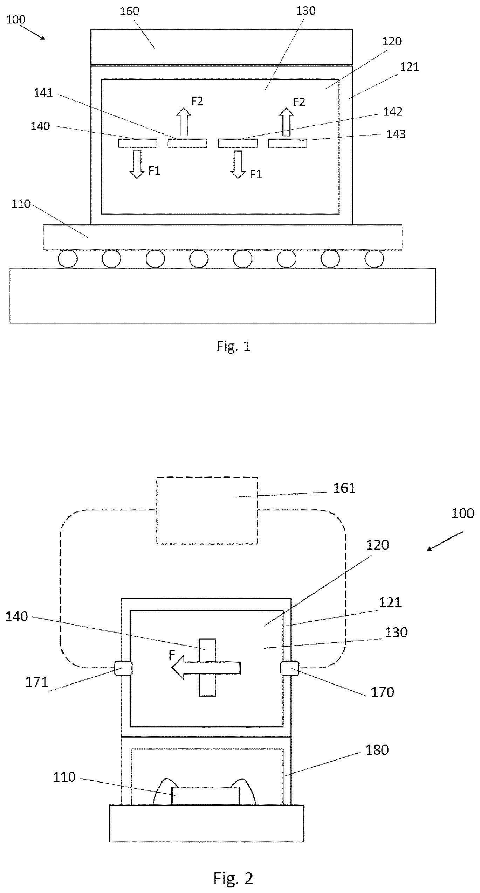

Figure 1 shows an arrangement 100 for thermal management 100 comprising an enclosure wall 121 defining an enclosure 120, which may be attached to a heat generating component 100. The heat generating component 110 may comprise, for example, a flip chip as shown in the present figure, a wire bonded component, or a tape automated bonded device being e.g. a processor. In some examples, the heat generating component may be a capacitor or a battery. Other embodiments may have the enclosure attached to a casing surrounding the heat generating component. Within the enclosure 120, a thermal management fluid may be provided. The thermal management fluid may be a cooling substance, for example comprising dielectric gas, boiling liquid, or a dielectric liquid 130. In case the thermal management fluid is a utilised as a boiling liquid, the enclosure wall may have a portion, such as a ceiling, forming a porous or capillary structure for allowing gas to escape the enclosure.

The embodiment displayed suggests a closed system where the dielectric fluid 130 is circulated within the enclosure 120, whilst other embodiments may comprise inlets and outlets allowing fluid to circulate out of, and in to, the enclosure 130.

Within the enclosure 130, the fluid may be caused to flow using flow units 140, 141, 142, 143. A flow unit 140 may comprise a first and a second electrode, and a flow F may be generated by applying a voltage over the electrodes. Decreasing or terminating the electric field between the electrodes may cause the flow F to decrease or stop, and the cooling effect may through this be decreased to achieve an optimal temperature for the heat generating component 110. Thus, the present invention allows for an isolating effect to be achieved, in which the flow may be stopped in order to in order allow heat to be accumulated at the heat generating component. In other words, the present invention allows for a regulation of the heat transfer between the heat generating component and e.g. a heat exchanger.

In this embodiment, the flow units 140-143 are located within the enclosure, at an intermediate distance between the enclosure wall 121 portion in thermal contact with the heat generating component 110 and the opposite portion of the enclosure wall 121. It will however be appreciated that other embodiments may comprise flow units located in other positions within the enclosure.

In the present embodiment, the flow units are positioned such that every other flow unit 140, 142 create a flow F1 towards the heat generating component 110 and the remaining flow units 141,143 create a fluid flow in a direction F2, away from the component 110. Further, a heat exchanger 160 may be arranged in thermal contact with the enclosure wall 121. The heat exchanger is in the present embodiment attached on top of the enclosure for dissipating heat transferred away from the component via the thermal management fluid. The heat exchanger 160 may form a heat pipe, heat sink a carbon fibre structure or a fluid tube or similar structures for transferring heat energy away from the fluid and the enclosure. Other embodiments may provide the heat exchanger 160 on the inside of the wall and connected to external pump arrangements.

Figure 2 shows an arrangement 100 comprising an enclosure 120 in thermal contact with a heat generating component 110. In this specific embodiment, the heat generating component 110 may be a wire bonded device, located within a housing 180. This housing, which also may be referred to as a capsule, may comprise a protective package, a heat sink or similar.

An enclosure wall 120, containing a dielectric thermal management fluid 130, may be attached to the outer wall of said housing. This attachment of the enclosure may be directly onto the housing, or may include a thermal interface material, for example comprising graphene, arranged between the enclosure and the housing.

In the present embodiment, the enclosure wall 121 encapsulating the dielectric fluid 130, is provided with an inlet 170 and an outlet 171. However, a plurality of inlets and/or outlets may also be utilized. Further, a flow unit 140 located within the enclosure 120 may comprise two electrodes. Applying a voltage over the electrodes may bring the dielectric fluid 130 to a flow F. In the current embodiment, the flow unit 140 is directed such that it allows the dielectric fluid to flow through the outlet, out of the enclosure. Further, the dielectric fluid may be lead from the enclosure to an external heat exchanger unit 161, which may for example comprise a carbon fibre structure or a fluid tube where heat is dissipated from the dielectric thermal management liquid. The cooled liquid may then be lead back into the enclosure through the inlet 170, where a cooling effect on the heat generating component 110 may be utilized.

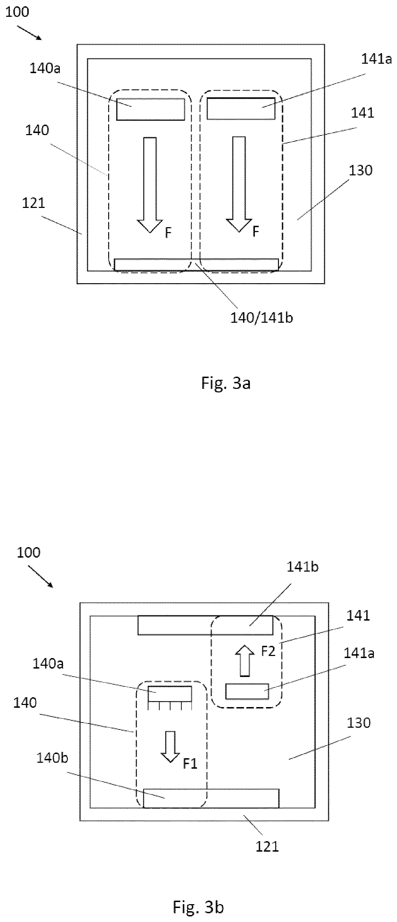

Figures 3a and 3b show embodiments of an arrangement 100 which may be similarly configured as the arrangement discussed in connection with figure 1 or 2. In these examples, the flow units 140 comprise a first electrode 140a, which may be referred to as an emitter electrode, and a second electrode 140b, which may be referred to as the collector electrode. In the shown arrangements, all flow units may be submerged in dielectric liquid 130. As illustrated, the enclosure 120 may be defined by the enclosure wall 121.

Figure 3a displays two flow units 140, 141 (indicated by dashed lines), wherein the first electrodes 140a, 141a of the respective flow units 140, 141 are separated from the second electrodes 140/141b, and the resulting flow F directed towards the component. In this embodiment, the first, emitter, electrodes are arranged within the volume defined by the enclosure wall 121, whilst the second, collector, electrode 140/141b is located on the inner surface of the enclosure wall 121. With a voltage applied, the first electrodes 140a, 141a may create a flow F of dielectric fluid toward the enclosure wall 121. This part of the enclosure wall may advantageously be in thermal contact with the heat generating component. Furthermore, in Figure 3a, the flow units 140 and 141 are shown to have one shared second electrode 140/141b, this meaning the second electrode 140/141b may function as a collector for multiple first electrodes 140a, 141a.

In Figure 3b, the second electrodes 140b, 141b are provided on the inside of the enclosure wall 121, both the ceiling and the floor of the enclosure wall 121. The first electrodes 140a, 141a may be located in the volume between the ceiling and the floor of the enclosure wall 121. Flow unit 140 is directing a flow F1 downwards, whilst 141 is directing a flow F2 upwards, towards the ceiling of the enclosure.

The different directions of the flow F1, F2 may be achieved due to at least two different, independent mechanisms. The first mechanism is the electron emitting structures, illustrated by the first electrode 140a which is shown to have surface structures that facilitates electron emission. In this embodiment they are depicted as tips or needles pointing in a downward direction and determining the emitting direction of the electrode 140a.

The second mechanism is the relative distance between the electrodes. The first electrode 141a has flow direction determined by the distance to the second electrode 140b, 141b. The shortest distance between first electrode 141a and second electrode 140b, 141b defines the direction of the flow F. In figure 3b, electrode 141a is located closer to the collector electrode 141b arranged on the enclosure ceiling than to the collector electrode 140b arranged on the enclosure floor, and therefore form flow unit 141 directing the flow toward the enclosure ceiling.

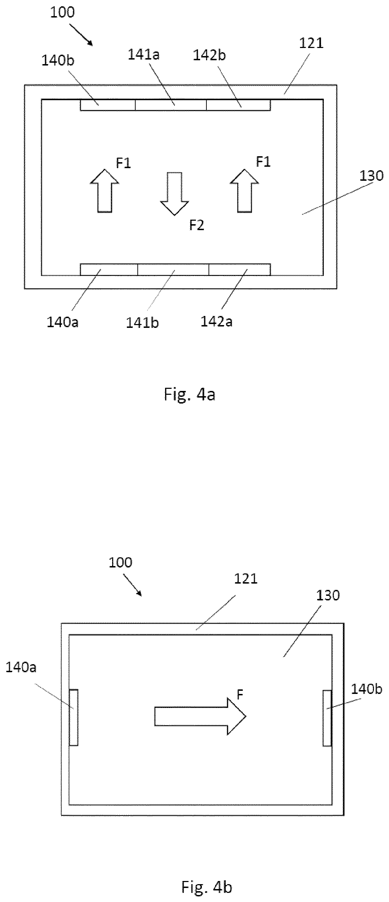

Figure 4a and 4b show embodiments of an arrangement 100 for thermal management, which may be similarly configured as the embodiments shown in the previous figures. In the present examples, the flow unit placements represent different alternatives for directing the flow F of thermal management fluid 130 within an enclosure, defined by an enclosure wall 121. The enclosure may be located on top of, and in thermal contact with, a heat generating component. The current embodiment depicts flow unit placements for directing flow towards and away from a heat generating component.

Figure 4a shows an embodiment in which electrodes 140a-142b are attached on the inner surface of the enclosure wall 121. In this embodiment the wall section 121 is provided with both first electrodes 140a-142a and second electrodes 140b-142b. The electrodes on the enclosure floor may comprise a second electrode 141b in the middle and two first electrodes 140a, 142a on the sides of the second electrode 141b. The opposite configuration is utilized on the enclosure ceiling 121, wherein second electrodes 140b, 142b are arranged on the sides and the first electrode 141a in the middle. As a result, three separate flow units are formed. This may result in flow a F2 towards the floor of the enclosure, which may be in thermal contact with a heat generating component, as well as flows F1 towards the ceiling, which may be in thermal contact with a heat exchanger.

Figure 4b shows an embodiment in which the flow F is directed parallel to the floor and may thus also be parallel to a heat generating component, upon which the enclosure may be attached. This embodiment displays a variation which may be suitable if the upstream side of a heat generating component is in greater need of cooling than the downstream side. This figure depicts the electrodes 140a, 140b located on the insides of the enclosure wall 121.The first electrode 140a may direct the flow towards the centre of the enclosure and the second electrode 140b may direct the flow away from it. This could create a flow F parallel to the ceiling or floor of the enclosure.

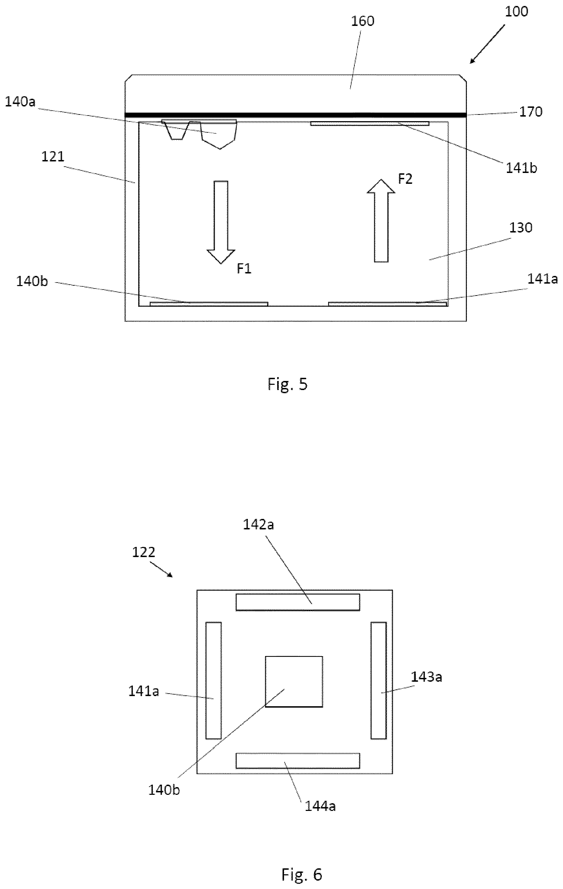

Figure 5 is a schematic representation of an arrangement 100 for thermal management, which may be configured in a similar way as any of the previously described embodiments. In figure 5, the enclosure wall 121 may be configured to increase the efficiency of the flow units. This may for example be achieved by providing a rough shape of the part of the enclosure wall 121 comprising the first electrode 140a so as to increase the surface area of said electrode 140a. This increase could potentially facilitate flow F1. Furthermore, specific shapes, such as peaks, could further facilitate flow. Further, a heat exchanger 160 may be arranged in thermal contact with the enclosure wall 121. The heat exchanger 160 may for example be a heat pipe or heat sink for dissipating thermal energy from the enclosure, and thus indirectly from the heat generating device. Between the enclosure wall 121 and the heat exchanger 160 may, in this embodiment, a thermal interface material 170, for example graphene, be arranged for increased heat transfer.

Figure 6 shows a top view of an enclosure floor 122 and a suggested electrode formation on the floor area. The present enclosure floor 122 may form part of an embodiment similar to the ones shown in the previous figures. In this instance the enclosure floor 122 may be equipped with electrodes, functioning as part of multiple flow units. Figure 6 represents an exemplary layout of first electrodes 141a - 144a and a second electrode 140b. In this embodiment, the second, collector, electrode 140b is placed in the middle of the enclosure floor whilst the emitting first electrodes 141a - 144a are placed along the sides of the component. This could for example benefit cooling of the central area of the enclosure floor which may be thermally connected on top of a heat generating device. The suggested electrode layout could create a tubular flow of thermal management fluid within the enclosure which may provide a cooling effect on a heat generating device on which the enclosure has been attached.

## Claims

1. An arrangement for thermal management (100) of a heat generating component (110), comprising:
an enclosure (120) configured to accommodate a dielectric liquid (130) in thermal contact with a wall portion of the enclosure; and
a first electrohydrodynamic, EHD, flow unit (140) arranged within the enclosure, wherein the first EHD flow unit comprises a first electrode (140a) and a second electrode (140b) arranged offset from the first electrode, and wherein the first EHD flow unit is configured to control a flow of the dielectric liquid between the first electrode and the second electrode in a direction perpendicular to the orientation of the first electrode and the second electrode, and wherein the first EHD flow unit is configured to direct the flow towards the heat generating component;
a second electrohydrodynamic, EHD, flow unit arranged within the enclosure, wherein the second EHD flow unit comprises a third electrode and a fourth electrode arranged offset from the third electrode, and wherein the second EHD flow unit is configured to control a flow of the dielectric liquid between the third electrode and the fourth electrode in a direction perpendicular to the orientation of the third electrode and the fourth electrode, and wherein the second EHD flow unit is configured to direct the flow away from the heat generating component; **characterized in that** at least one of the first and second electrode is arranged on an inner surface portion of the enclosure, and wherein at least one of the third and fourth electrode is arranged on an inner surface portion of the enclosure, such that at least a portion of the inner surface of the enclosure is utilized as a part of the first and second EHD flow units, as an electrode; and,
wherein the wall portion is configured to be arranged in thermal contact with the heat generating component so as to allow heat to be dissipated from the heat generating component through the dielectric liquid.

2. The arrangement according to claim 1, wherein the enclosure further comprises an inlet (170) and an outlet (171) for allowing the dielectric liquid to flow into and out from the enclosure.

3. The arrangement according to claim 2, wherein the inlet and the outlet are configured to circulate the dielectric liquid to an external heat exchanger (161).

4. The arrangement according to any one of the preceding claims, further comprising a heat exchanger (160) arranged in thermal contact with the enclosure so as to allow heat to be dissipated from the dielectric liquid.

5. The arrangement according to any one of the preceding claims, wherein the wall portion is configured to be arranged on a housing enclosing the heat generating component.

6. The arrangement according to any one of the preceding claims, wherein the wall portion is configured to be arranged on a heat spreader of the heat generating component.

7. The arrangement according to claim 5 or 6, wherein the wall portion is configured to be arranged on an intermediate thermal interface material, TIM (170).

8. The arrangement according to any one of the preceding claims, wherein said at least one of the first and second electrodes is formed by a graphene layer provided on the inner surface of the enclosure.

9. The arrangement according to any one of the preceding claims, wherein the first and second EHD flow units are positioned in a grid structure.

10. The arrangement according to claim 9, wherein the first and second EHD flow units are positioned in a grid structure in one of
a common plane, and
different layers.

## Patentansprüche

1. Anordnung zum Wärmemanagement (100) einer wärmeerzeugenden Komponente (110), umfassend:
eine Einfassung (120), die dazu ausgebildet ist, eine dielektrische Flüssigkeit (130) in thermischem Kontakt mit einem Wandabschnitt der Einfassung aufzunehmen; und
eine erste elektrohydrodynamische, EHD, Strömungseinheit (140), die im Inneren der Einfassung angeordnet ist, wobei die erste EHD-Strömungseinheit eine erste Elektrode (140a) und eine zweite Elektrode (140b), die von der ersten Elektrode versetzt angeordnet ist, umfasst, und wobei die erste EHD-Strömungseinheit dazu ausgebildet ist, eine Strömung der dielektrischen Flüssigkeit zwischen der ersten Elektrode und der zweiten Elektrode in einer Richtung senkrecht zur Orientierung der ersten Elektrode und der zweiten Elektrode zu steuern, und wobei die erste EHD-Strömungseinheit dazu ausgebildet ist, die Strömung zu der wärmeerzeugenden Komponente hin zu lenken;
eine zweite elektrohydrodynamische, EHD, Strömungseinheit, die im Inneren der Einfassung angeordnet ist, wobei die zweite EHD-Strömungseinheit eine dritte und eine vierte Elektrode, die von der dritten Elektrode versetzt angeordnet ist, umfasst, und wobei die zweite EHD-Strömungseinheit dazu ausgebildet ist, eine Strömung der dielektrischen Flüssigkeit zwischen der dritten Elektrode und der vierten Elektrode in einer Richtung senkrecht zur Orientierung der dritten Elektrode und der vierten Elektrode zu steuern, und wobei die zweite EHD-Strömungseinheit dazu ausgebildet ist, die Strömung von der wärmeerzeugenden Komponente weg zu lenken; **dadurch gekennzeichnet, dass** wenigstens eine von der ersten und zweiten Elektrode auf einem Innenflächenabschnitt der Einfassung angeordnet ist, und wobei wenigstens eine von der dritten und vierten Elektrode auf einem Innenflächenabschnitt der Einfassung angeordnet ist, so dass wenigstens ein Abschnitt der Innenfläche der Einfassung als ein Teil der ersten und zweiten EHD-Strömungseinheit, als eine Elektrode verwendet wird; und,
wobei der Wandabschnitt dazu ausgebildet ist, in thermischem Kontakt mit der wärmeerzeugenden Komponente angeordnet zu sein, um die Ableitung von Wärme von der wärmeerzeugenden Komponente durch die dielektrische Flüssigkeit zu ermöglichen.

2. Anordnung nach Anspruch 1, wobei die Einfassung ferner einen Einlass (170) und einen Auslass (171) umfasst, um es der dielektrischen Flüssigkeit zu ermöglichen, in die Einfassung hinein und aus dieser heraus zu strömen.

3. Anordnung nach Anspruch 2, wobei der Einlass und der Auslass dazu ausgebildet sind, die dielektrische Flüssigkeit zu einem externen Wärmetauscher (161) strömen zu lassen.

4. Anordnung nach einem der vorhergehenden Ansprüche, ferner umfassend einen Wärmetauscher (160), der in thermischem Kontakt mit der Einfassung angeordnet ist, um die Ableitung von Wärme aus der dielektrischen Flüssigkeit zu ermöglichen.

5. Anordnung nach einem der vorhergehenden Ansprüche, wobei der Wandabschnitt dazu ausgebildet ist, auf einem Gehäuse angeordnet zu sein, das die wärmeerzeugende Komponente einfasst.

6. Anordnung nach einem der vorhergehenden Ansprüche, wobei der Wandabschnitt dazu ausgebildet ist, auf einem Wärmeverteiler der wärmeerzeugenden Komponente angeordnet zu sein.

7. Anordnung nach Anspruch 5 oder 6, wobei der Wandabschnitt dazu ausgebildet ist, auf einem zwischenliegenden Wärmeleitmaterial TIM (170) angeordnet zu sein.

8. Anordnung nach einem der vorhergehenden Ansprüche, wobei die wenigstens eine von der ersten und zweiten Elektrode von einer Graphenschicht gebildet ist, die auf der Innenfläche der Einfassung vorgesehen ist.

9. Anordnung nach einem der vorhergehenden Ansprüche, wobei die erste und die zweite EHD-Strömungseinheit in einer Gitterstruktur positioniert sind.

10. Anordnung nach Anspruch 9, wobei die erste und die zweite EHD-Strömungseinheit in einer Gitterstruktur in einem von einer gemeinsamen Ebene und verschiedenen Schichten positioniert sind.

## Revendications

1. Agencement de gestion thermique (100) d'un composant générant de la chaleur (110), comprenant :
une enceinte (120) configurée pour recevoir un liquide diélectrique (130) en contact thermique avec une portion de paroi de l'enceinte ; et
une première unité d'écoulement électrohydrodynamique, EHD (140), agencée à l'intérieur de l'enceinte, dans lequel la première unité d'écoulement EHD comprend une première électrode (140a) et une deuxième électrode (140b) agencée de manière décalée par rapport à la première électrode, et dans lequel la première unité d'écoulement EHD est configurée pour contrôler un écoulement du liquide diélectrique entre la première électrode et la deuxième électrode dans une direction perpendiculaire à l'orientation de la première électrode et de la deuxième électrode, et dans lequel la première unité d'écoulement EHD est configurée pour diriger l'écoulement vers le composant générant de la chaleur ;
une deuxième unité d'écoulement électrohydrodynamique, EHD, agencée à l'intérieur de l'enceinte, dans lequel la deuxième unité d'écoulement EHD comprend une troisième électrode et une quatrième électrode agencée de manière décalée par rapport à la troisième électrode, et dans lequel la deuxième unité d'écoulement EHD est configurée pour contrôler un écoulement du liquide diélectrique entre la troisième électrode et la quatrième électrode dans une direction perpendiculaire à l'orientation de la troisième électrode et de la quatrième électrode, et dans lequel la deuxième unité d'écoulement EHD est configurée pour éloigner l'écoulement du composant générant de la chaleur ;
**caractérisé en ce qu'**au moins une électrode parmi la première électrode et la deuxième électrode est agencée sur une portion de la surface interne de l'enceinte, et dans lequel au moins une électrode parmi la troisième électrode et la quatrième électrode est agencée sur une portion de la surface interne de l'enceinte, de telle sorte qu'au moins une portion de la surface interne de l'enceinte est utilisée comme une partie des première et deuxième unités d'écoulement EHD, comme une électrode ; et
dans lequel la portion de paroi est configurée pour être agencée en contact thermique avec le composant générant de la chaleur de manière à permettre à la chaleur d'être dissipée du composant générant de la chaleur via le liquide diélectrique.

2. Agencement selon la revendication 1, dans lequel l'enceinte comprend en outre une entrée (170) et une sortie (171) pour permettre au liquide diélectrique de s'écouler dans et hors de l'enceinte.

3. Agencement selon la revendication 2, dans lequel l'entrée et la sortie sont configurées pour faire circuler le liquide diélectrique vers un échangeur de chaleur externe (161).

4. Agencement selon l'une quelconque des revendications précédentes, comprenant en outre un échangeur de chaleur (160) agencé en contact thermique avec l'enceinte de manière à permettre la dissipation de la chaleur du liquide diélectrique.

5. Agencement selon l'une quelconque des revendications précédentes, dans lequel la portion de paroi est configurée pour être agencée sur un boîtier renfermant le composant générant de la chaleur.

6. Agencement selon l'une quelconque des revendications précédentes, dans lequel la portion de paroi est configurée pour être agencée sur un répartisseur de chaleur du composant générant de la chaleur.

7. Agencement selon la revendication 5 ou 6, dans lequel la portion de paroi est configurée pour être agencée sur un matériau d'interface thermique, TIM - Thermal Interface Material (170), intermédiaire.

8. Agencement selon l'une quelconque des revendications précédentes, dans lequel ladite au moins une électrode parmi les première et deuxième électrodes est formée par une couche de graphène pourvue sur la surface interne de l'enceinte.

9. Agencement selon l'une quelconque des revendications précédentes, dans lequel les première et deuxième unités d'écoulement EHD sont positionnées selon une structure en grille.

10. Agencement selon la revendication 9, dans lequel les première et deuxième unités d'écoulement EHD sont positionnées selon une structure en grille
soit dans un plan commun,
soit en différentes couches.
